# EUROPEAN PATENT APPLICATION

(11) **EP 0 862 210 A2**
(43) Date of publication of application: **02.09.1998**
(21) Application number: 98300721.2
(22) Date of filing: 02.02.1998
(51) Int. Cl.: H01L 23/467

(54) **Heat dissipating assembly**

(30) Priority: 31.01.1997 US 792864
(71) Applicant: THERMALLOY INCORPORATED, Dallas TX 75381-0839 (US)
(72) Inventor: Edwards, Steven F., Dallas, Texas 75208 (US); Jordan, William D., Dallas, Texas 75205 (US)
(74) Representative: Sorrell, Terence Gordon

(57) **Abstract**

Highly efficient heat sink assemblies are formed using a thermally conductive body (10) by positioning a fan (14) in a cavity (12) intermediate the ends of the body which defines a plurality of channels (22). Air is forced through the channels by the fan to cool the opposed surfaces of the heat sink body.

## Description

This invention relates to dissipation of thermal energy generated by electronic devices and the like. More particularly, it relates to assemblies including a fan within a cavity in the body of a heat sink which forces air through channels in the heat sink to dissipate thermal energy into the surrounding environment.

### BACKGROUND OF THE INVENTION

Many electronic devices and electrical systems such as power controls, switches, variable speed motor controls, microprocessors and the like generate heat during operation. This heat must be removed to avoid damaging the device. The capability of some electronic devices is limited by their ability to remove or expel internally generated heat and thereby avoid general or localized thermal degradation or failure. Apparatus for removing and dissipating such excess thermal energy (generally referred to as heat sinks) are thus necessary for proper operation of systems incorporating such devices.

For purposes of the present invention, a heat sink is any body of metal or like material which is placed in thermal communication with an electronic device or device package for transferring internally generated heat from the device and dissipating such heat to the surrounding environment by conduction, convection and/or radiation. Accordingly, heat sinks are generally made of materials which exhibit high thermal conductivity such as aluminium, copper and alloys thereof.

A typical heat sink functions by conducting heat away from the heat-generating component and dissipating the heat into the surrounding air. In order for the heat sink to operate efficiently, it must be secured to (or placed in good thermal contact with) the heat-generating component. Various means have been used to attach heat sinks in thermal contact with electronic device packages. Heat sinks may be secured to a predetermined surface of the electronic device package with heat-conductive epoxy, glue or the like. Heat sinks may also be mechanically attached to electronic device packages with resilient metal clips mounted on the heat sink or with screws, bolts, clamps or other connective means which urge the heat sink and device package into mutual contact. Such mechanical means generally enable the heat sink to be easily removed from the package.

A heat sink must dissipate heat at a rate at least as fast as the attached component or components generate heat. As electronic components decrease in size while increasing in power and speed, the need for compact efficient heat dissipation means intensifies and the demands on heat sink design escalate. Accordingly, significant research and development has been devoted to designing compact heat sinks having large heat dissipating capacity which may be manufactured in mass quantities at reasonable costs.

The rate at which a heat sink dissipates heat may be increased by increasing the surface area of the heat sink and by shaping the heat sink such that it effectively uses the surrounding air currents. Thus, thermal performance is a function, at least in part, of adequate conduction path and surface area. Accordingly, heat sinks are typically designed in shapes which enlarge their surface areas by means of protrusions such as fins or pins extending from a base portion which is in thermal contact with the heat-generating component. Heat sink designers often utilize fins with widely varying shapes and dimensions for assorted applications.

In addition to the demand for compact highly efficient heat sinks, some applications require heat sink designs which control the air used to cool the heat sink. United States Letters Patent No 4,884,331 to Hinshaw describes heat sinks which have been successfully used for relatively small semiconductor device packages such as those primarily designed for computer applications. Fans may be used in conjunction with such heat sinks to form miniature thermal cooling modules. These small thermal cooling modules (TCMs) have been found to exhibit thermal impedance values in the range of about 1.0°C/W. Such modules, however, are much too limited for use in large power controls and the like. Large systems such as traction drives, variable speed motor controls and the like employ high power semiconductor devices such as insulated gate bipolar transistors (IGBTs) or the like and require heat dissipating apparatus which exhibit thermal impedance values of less than about 0.3°C/W to achieve acceptable energy dissipation in a reasonably-sized control system. To achieve such thermal impedance values, forced convection cooling units such as those supplied by Alutronic, 5884 Halver, Auf der Lobke 9-11, Postfach 12 03, Germany, have been extensively used. Similar apparatus is produced by Aavid Engineering, Inc of Laconia, New Hampshire. Such conventional apparatus generally comprises a plurality of thin parallel fins longitudinally bonded within a rectangular housing. The housing may also comprise a compression chamber for forcing air into the fin section in order to provide a uniform flow of air through the fins. However, in order to provide a cooling structure which exhibits a thermal impedance value of substantially less than 1°C/W, these devices require a heat sink of extremely large volume. For example, a typical forced conventional cooler for IGBTs and the like is the model LK40-200Q apparatus sold by Alutronic. This apparatus exhibits a thermal impedance value of about 0.044°C/W, but occupies a volume of about two hundred and six (206) cubic inches.

As applications of heavy duty power control systems and the like expand, it is desirable that the space required by the systems which cool the power devices be reduced. Until fairly recently, the lowest volume performance value (determined by multiplying volume (V) times thermal impedance (R 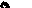 ) (and expressed as R 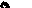 V) for forced air cooling apparatus was about 6.0°C in³/W.

United States Letters Patent No 5,486,980 to Hinshaw (which is herein incorporated by reference) describes a further advancement in heat sink engineering whereby forced air heat sinks achieve volume performance values substantially lower than 6.0°C in³/W. Such heat sink apparatus is produced by providing thermally conductive bases with one face adapted to be attached in thermal communication with the device to be cooled and having a plurality of substantially parallel pins extending from another face thereof, the surface area of the pins being sufficient to provide a thermal impedance of substantially less than about 1.0°C/W (preferably less than about 0.3°C/W) when cooled with air forced substantially axially with respect to the pins and toward the base at an average velocity of at least about four hundred (400) feet per minute. When the pins are properly spaced, the dimensions of the space occupied by the heat sink body and pins is reduced sufficiently to form a heat sink body having thermal impedance values (R 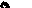 ) of less than about 0.3°C/W and volume performance values (R°V) of less than about 6.0°C in³/W. That apparatus, includes a fan mounted for forcing air through the grooves and between the pins toward the base.

While limitations of present design heat sinks were tolerated in the past, circuit densities have increased so greatly that that thermal dissipation is often the critical limitation on performance. It is now desirable to have heat sinks suitable for cooling not only semiconductor modules and devices, but also larger electrical systems such as power controllers, traction drives, variable speed motor controls and the like as well as individually housed systems such as personal computers, etc. with forced air and directional air flow so that the air passing through the housing removes heat most efficiently.

### SUMMARY OF THE INVENTION

In accordance with the present invention heat dissipating assemblies are formed which employ a fan to force air through channels formed by thin walls connecting opposed faces of a thermally conductive body. The fins or walls extend between plates which form the outer faces of the heat sink body and are spaced apart to define adjacent channels which extend the length of the heat sink body. A cavity formed in the body and extending through one face communicates with all the channels and a fan is mounted in the cavity for forcing air through the channels defined by the walls. By forcing air to flow through the confined channels and through the fan (or *vice versa*) the efficiency of heat transfer to the air is greatly improved. This is particularly true for radial rather than axial flow fans due to the lower pressure drop, hence higher velocity achieved since the flow turning head loss is eliminated. By mounting the fan within a cavity in the body, the overall dimensions of the assembly are substantially reduced. Furthermore, by confining flow of cooling air through ducts which are open only at the ends, the flow of exhaust can be more readily controlled and directed. Furthermore, thermal energy transferred from the heat sink to the air is more predictably controlled. Other features and advantages of the invention will become more readily understood from the following detailed description taken in conjunction with the appended claims and attached drawings in which:

### BRIEF DESCRIPTION OF THE DRAWING

Fig. 1 is a perspective exploded view of heat dissipating apparatus incorporating the principles of the invention;
Fig. 2 is a perspective view of the embodiment of Fig 1 in assembled condition;
Fig. 3 is a bottom perspective view of the assembly of Fig.2;
Fig. 4 is a partial cut-away view of a system housing in which is mounted the assembly of Fig.2;
Fig. 5 is a partially exploded perspective view of an alternative embodiment of heat dissipating apparatus incorporating the principles of the invention;
Fig. 6 is a perspective view of an embodiment of the invention employing alternate means for mounting electronic device packages thereon.; and
Fig. 7 is an end view of another embodiment of the invention illustrating the mounting by insertion of a card and direct mounting of device packages.

Like numerals refer to like parts throughout the several views of the drawing.

### DESCRIPTION OF THE PREFERRED EMBODIMENTS

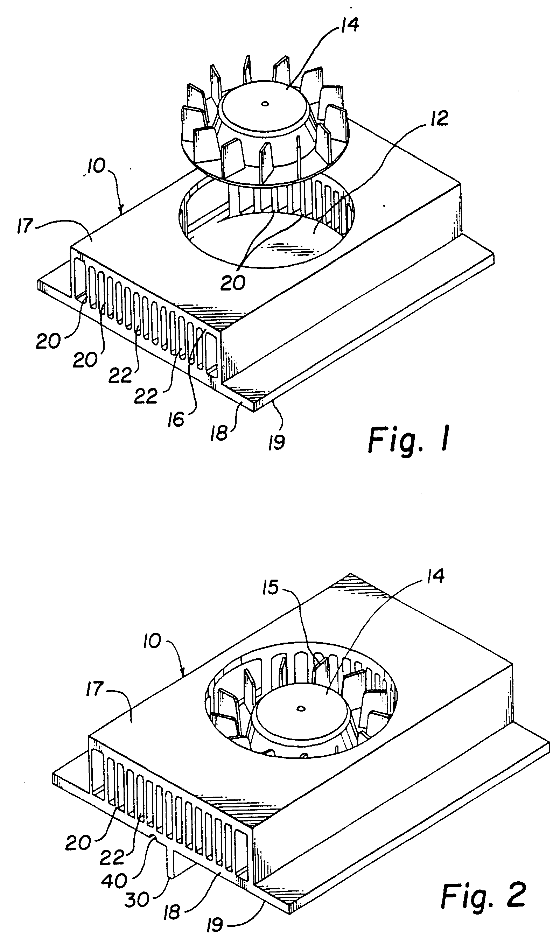

In the embodiment illustrated, the heat dissipating assembly of the invention comprises a thermally conductive body **10** having a centrally located cavity **12** into which a rotary fan **14** is mounted. The body 10 may be formed of any suitable thermally conductive material such as aluminum, copper or alloys thereof. In the preferred embodiment, the body is formed by extrusion to form a monolithic unitary body 10 which includes a first plate **16** and second oppositely disposed plate **18** interconnected by a plurality of spaced apart walls or fins **20**. Where the body 10 is formed by extrusion, the walls 20 will be parallel and adjacent channels **22** will also be parallel and extend through the length of body 10. It will be recognized that the body 10 may, of course, be formed by other methods such as stamping, machining, etc. In such cases, the walls 20 need not be parallel and the channel 22 (defined by walls 20) need not direct flow in parallel directions. For purposes of this disclosure, reference is made to the embodiment as shown in Fig 1 wherein the walls are parallel and define parallel channels. Other configurations made by other processes will be apparent to those skilled in the art.

As illustrated in Fig 1, the first plate 16 defines a top face **17** and second plate 18 defines an oppositely disposed bottom face **19**. The thicknesses of the plates 16, 18 will depend on the thermal conductivity of the material used, the method of manufacture and the physical requirements of the electronic devices to be supported thereon. It will be readily recognized that electronic device packages may be mounted on the top face as well as the bottom face, both of which will be equally cooled by the assembly of the invention.

An opening is formed in the first plate 16 intermediate the ends of the channels. The diameter of the opening is at least as large as the distance separating the two outermost of the channels extending through the body 10 so that the cavity 12 formed divides the channels into two opposed sets of channels, all of which are in individual communication with the cavity 12.

A radial (impeller) fan **14** having blades **15** is mounted within cavity 12 so that when fan 14 rotates air is moved through channels 22. The blades 15 on fan 14 may be adapted to draw air through the fan 14 and exhaust out through the channels 22 (in which case air will flow in opposite directions through the opposed sets of channels outwardly from the fan) or to draw air through the channels 22 and exhaust outwardly through the fan (in which case air will be drawn through the outer ends through each of the channels and pulled in opposite directions toward the fan). Regardless of the direction of air flow through the body 10, air flows through channels 22 to absorb thermal energy from the walls 20 and opposed plates 16, 18 which define channels 22. Other means for injecting air into the cavity such as externally mounted blowers with ducts directing such to the cavity 12 can be used.

The invention may take various forms and is suitable for use in a wide variety of operations. The fan 14 may be mounted partially inserted into the cavity 12 or totally inserted into the cavity. Where the fan 14 is positioned within the cavity 12 a considerable reduction of noise is achieved. More significantly, the volume of air forced through the channels 22 is higher due to the lower pressure drop achieved by reducing the flow length to about 50% of that of conventional fin structures. By fitting the fan 14 within the cavity 16 the entire output of the fan is directed through the channels 22, eliminating the flow turning head loss. Furthermore, since the channels 24 act as shrouded fins, the flow of air over the walls 21 may be described as ducted flow over fins. The opposed plates 16, 18 act as shrouds which prevent scattered escape of air, thus improving heat transfer efficiency and cooling by controlling the volume and direction of flow.

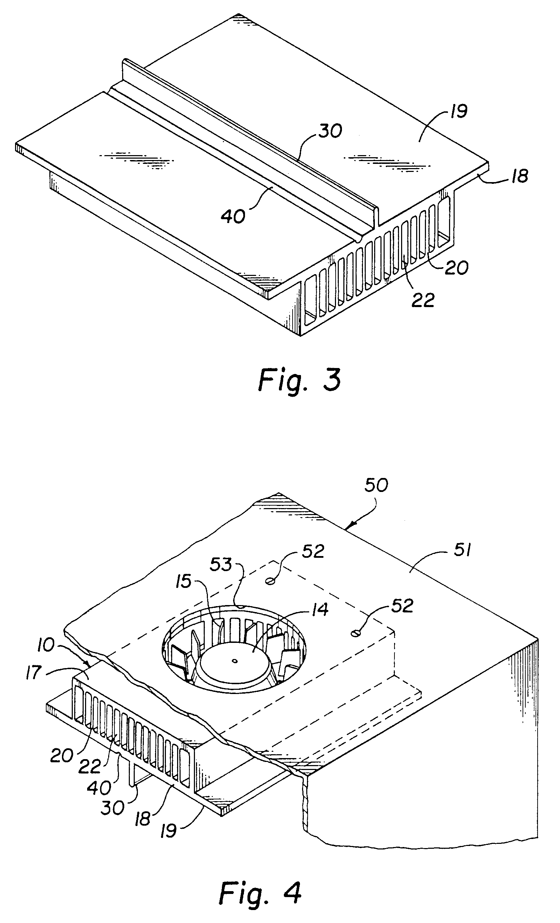

The body 10 may include a flange or mounting plate **30** (shown more clearly as Figs. 3, 6 and 7) extending therefrom substantially perpendicular to the bottom face 19. Where the body 10 (or at least plate 18) is formed by extrusion, the flange 30 may be formed as an integral part thereof. The flange 30 may of course be added by welding, bolting, gluing or otherwise securing it to face 19.

The flange 30 provides a convenient platform for mounting device packages in direct thermal communication with the bottom plate 18. Similarly one or more grooves **40** (see Fig. 3) may be formed in bottom face 19 into which the edge of circuit card or the like may be inserted. When a card is mounted in groove 40, device packages **75** may be mounted directly on the face 19 and electrically interconnected with circuitry on the card.

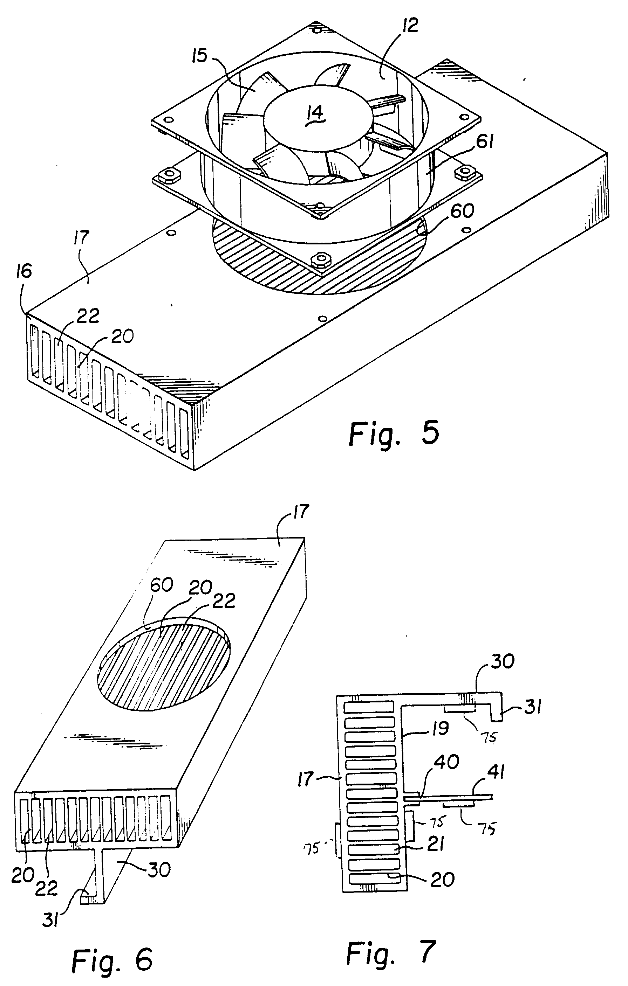

Flange 30 may include one or more lips **31** (see Fig. 6) which extend therefrom in a plane or planes substantially parallel with bottom face 19. Lips 31 may extend in either direction from flange 30. The lips 31 in cooperation with face 19 and the face of flange 30, provide convenient surfaces for mounting electronic devices, circuit cards, *etc*., so that as many as three (3) closely-spaced flat faces are available as mounting surfaces.

The ducted fin heat sink apparatus of the invention may be used to provide cooling for small as well as large electronic devices. The walls 20 may be straight and parallel (as shown) or may be corrugated, curled or otherwise configured to direct air through enclosed channels which are formed by the walls and opposed plates. The sizes of the channels may vary as desired, depending on required air flow and fan capacity.

The heat sink body may be fabricated by any of various processes. For example, the body may be formed by extrusion wherein the walls 20 are parallel and extend in the longitudinal direction to define parallel channels 22. The body 10 may also be formed by sawing, machining or stamping a plurality of grooves into one plate and placing a second plate parallel on the first plate to enclose the grooves and form channels 22. In this embodiment the shape and size of channels 22 is limited by groove formation process. Similarly, the body 10 could be formed by sandwiching a corrugated or folded sheet between two plates. All such similar arrangements will provide similar results.

If the body 10 is formed of two or more mating components on one or more of which fins are formed which define the walls of the channels 22 in the assembled body, the fins may be cross cut (or otherwise severed) to form rows of pins which form discontinuous walls. The channels thus formed will not be isolated from each other. Instead, the body 10 will form a plenum-like chamber into which the pins extend. Air forced through such a chamber will not be confined to separate channels. However, the use of pins extending into a larger chamber may yield improved efficiencies in cooling.

The manufacturing and assembly process may be simplified by using the structural arrangement shown in Fig. 5. In this embodiment fins 20 extend between plates 16, 18 to define parallel channels 22 as described above. However, instead of forming a cavity (shown at 12 in Fig. 1) within the body of the fins, an opening **60** is formed in the plate 16 which exposes all the channels 22. A plenum or duct **61** is mounted over opening 15 to form a cavity 12 adjacent the top edges of the fins 22 instead of adjacent the internal ends as shown in Fig. 1. Fan 14 mounted in cavity 12 forces (or draws) air through the channels 22 as described above. In this embodiment an axial flow fan may be used to force air into the channels 22. Since the fan 14 is placed directly adjacent the exposed edges of the walls 20 (and thus channels 22) very little flow-turning head loss is encountered. While this embodiment is somewhat simpler to fabricate, it occupies a slightly greater overall volume for the same heat-dissipating capacity.

Regardless of the process of fabrication, the heat sink body 10 may be anodized or otherwise treated for protection against corrosion and to enhance the heat dissipation characteristics thereof.

The heat dissipating assembly described above finds particular utility when used in combination with an enclosure, housing or the like which contains an electronic system (such as a personal computer or the like) which employs various heat-producing electronic devices. For example, personal computers employ computer chips which generate substantial heat and must be forcibly cooled as well as other circuitry, such as power supplies or like, which also generate heat within the system enclosure. A small fan is often mounted in the housing to either force air into or out of the enclosure. Generally, the fan is situated on a back or bottom wall and exhausts air from the enclosure, relying on inlet vents or cracks, holes, *etc*., of the housing for inlet of ambient air.

As shown in Fig. 4, the assembly of the invention may be used as an integral portion of a housing and cooling system by placing the cavity 12 in registry with an aperture **53** in an external wall **51** of housing or enclosure **50**. The cooler external air passes over the heat sink first, thereby reducing the temperature of the more critical components before being exhausted to the less critical component areas. The body 10 may be secured to the wall 51 by screws **52**, glue, epoxy or other means such as clamps or mating tongue and groove slotted assemblies. With body 10 arranged to align cavity 12 with aperture 53, fan 14 may draw ambient air into body 10, through channels 22 and into the interior of the enclosure 50. The most critical heat-producing devices (such as microprocessors, *etc.*) may thus be mounted directly on the body 10 and directly cooled with lowest temperature air in the enclosure, *i.e.* incoming air. The air is then exhausted into the enclosure and allowed to escape through vents, etc., to sweep hot air from the housing 50. Vents may be placed as desired to control flow through the enclosure. If desired, the outer wall 51 of the housing 50 may be used as the top plate 16 and the body 10 comprising bottom plate 18 and the walls 20 affixed thereto by any suitable means so that the wall 51, in cooperation with walls 20 and bottom plate 18 defines channels 22.

Thermal impedance is a function of convection heat transfer coefficient and thus ordinarily must be expressed in terms of such variables as cooling fluid, cooling fluid flow rates and the like. However, it is common practice to refer to the "thermal impedance" or "thermal resistance" of a heat sink in absolute numbers since the variables are essentially predetermined. As disclosed herein the cooling fluid is ambient (room temperature) air and, unless stated otherwise, air flow is normal convection. Thus the thermal impedance at any temperature is a definite value. Where forced air is contemplated, it is common knowledge that thermal impedance decreases with increased air flow but that the rate of increase decreases rapidly and is, for practical purposes, negligible above one thousand (1000) feet per minute. For most design considerations, standard conditions are assumed to be at least about four hundred (400) feet per minute air flow.

The unique structure of the ducted fin heat sink arrangement provides unique and valuable characteristics. Large cooling systems (such as produced by Aavid, Alutronic, etc.) exhibit thermal impedance values at standard conditions which are below the arbitrary 0.3°C/W value accepted as the maximum accepted value. These systems, however, are quite bulky. Heat dissipation assemblies made in accordance with the invention exhibit thermal impedance values below 0.3°C/W with volume performance values (R°V) as low as 6.0°C in³/W. The structures of the invention, therefore, can accomplish effective cooling of large as well as small electronic systems while occupying, substantially less physical volume than occupied by conventional cooling systems.

Although the invention has been described herein with reference to specific forms thereof, many alternatives, modifications and variations will become apparent to those skilled in the art in light of the foregoing disclosure. Accordingly, the foregoing disclosure is to be construed as only illustrative and for the purpose of teaching those skilled in the art the manner of carrying out the invention. The forms of the invention shown and described in detail are to be taken as the presently preferred embodiments. Various changes may be made without departing from the concept and scope of the invention as defined by the appended claims.

## Claims

1. A thermally conductive body (10) having:
i) a first plate (16) defining a top face (17);
ii) a second plate (18) having first and second ends and defining an oppositely disposed bottom face (19);
iii) a plurality of walls (20) connecting said first plate and said second plate defining, in co-operation with said first plate and said second plate, a plurality of channels (22) extending substantially parallel with said top face and said bottom face; and
iv) an opening in said first plate intermediate the ends of said second plate forming a cavity (12) in fluid communication with all said channels;
whereby said thermally conductive body defines a plurality of channels extending in at least two directions from said cavity.

2. A thermal energy dissipating assembly comprising:
a) a thermally conductive body (10) having:
i) a first plate (16) defining a top face (17);
ii) a second plate (18) having first and second ends and defining an oppositely disposed bottom face (19);
iii) a plurality of fins (20) connecting said first plate and said second plate defining, in co-operation with said first plate and said second plate, a plurality of channels (22) extending substantially parallel with said top face and said bottom face; and
iv) an opening in said first plate intermediate the ends of said second plate and forming a cavity (12) in fluid communication with all said channels;
whereby said thermally conductive body defines a plurality of channels extending in at least two directions from said cavity; and
b) a fan 14 positioned within said cavity and adapted to move air through said channels.

3. The thermally conductive body claimed in Claim 1, or a thermal energy dissipating assembly as claimed in claim 2 wherein said body is a unitary monolithic body.

4. The thermally conductive body claimed in Claim 1, or a thermal energy dissipating assembly as claimed in claim 2 wherein said top face and said bottom face define mounting surfaces for electronic device packages (75).

5. The thermally conductive body claimed in Claim 1, or a thermal energy dissipating assembly as claimed in claim 2 wherein the said walls, or said fins, are substantially parallel and extend from said cavity to said first end or said second end of said second plate.

6. The thermally conductive body claimed in Claim 1, or a thermal energy dissipating assembly as claimed in claim 2 wherein the surface area defined by said bottom face is greater than the surface area defined by said top face.

7. The thermally conductive body claimed in Claim 1, or a thermal energy dissipating assembly as claimed in claim 2 wherein said opening in said first plate extends at least partially into said walls, or said fins, to define a cavity which is at least partially between said first plate and said second plate.

8. The thermally conductive body claimed in Claim 1, or a thermal energy dissipating assembly as claimed in claim 2 wherein said opening in said first plate provides communication with a cavity formed adjacent said first plate.

9. The thermally conductive body claimed in Claim 1, or a thermal energy dissipating assembly as claimed in claim 2 wherein said walls, or said fins, are not parallel with each other.

10. The thermally conductive body claimed in Claim 1, or a thermal energy dissipating assembly as claimed in claim 2 wherein said walls, or said fins, are defined by spaced-apart pins, e.g. arranged in rows.

11. The thermally conductive body claimed in Claim 1, or a thermal energy dissipating assembly as claimed in claim 2 wherein the body is provided with a flange (30) extending from said bottom face.

12. An assembly for dissipating thermal energy comprising:
a) a thermally conductive body (10) having:
i) a first plate (16) defining a top face (17);
ii) a second plate (18) having first and second ends and defining an oppositely disposed bottom face (19);
iii) a plurality of fins (20) extending between said first plate and said second plate defining, in co-operation with said first plate and said second plate, a plurality of channels (22) extending substantially parallel with said top face and said bottom face; and
iv) an opening in said first plate intermediate the ends of said second plate extending through said first plate providing a cavity (12) in fluid communication with all said channels;
whereby said thermally conductive body defines a plurality of channels extending in generally opposite directions from said cavity; and
b) means (14) mounted within said cavity to move air through said channels.

13. An assembly as claimed in claim 12 wherein said means (14) to move air is totally confined within said cavity.

14. An assembly as claimed in claim 12 wherein said means (14) moves air from said cavity towards said ends of said bottom plate.

15. An assembly as claimed in claim 12 wherein said means (14) moves air from said ends of said bottom plate towards said cavity.

16. An assembly as claimed in claim 12, further including at least one electronic device package (75) secured to said top face and at least one electronic device package secured to said bottom face.

17. An assembly as claimed in claim 12 wherein said cavity is defined by a chamber adjacent said first plate.

18. An assembly as claimed in claim 12 including a flange (30) extending from said bottom face.

19. An assembly as claimed in claim 18 including a lip (31) extending from said flange.

20. An assembly according to claim 18 including a groove (40) in said bottom face.

21. Apparatus for removing heat from electronic circuitry substantially enclosed within a housing comprising:
(a) a housing (50) substantially enclosing electrical circuitry which includes heat-producing electronic devices, said housing having at least one wall (51) which includes an aperture (53);
(b) a thermally conductive body (10) having:
i) a first plate (16) defining a top face (17);
ii) a second plate (18) having first and second ends and defining an oppositely disposed bottom face (19);
iii) a plurality of fins (20) connecting said first plate and said second plate defining, in co-operation with said first plate and said second plate, a plurality of channels (22) extending substantially parallel with said top face and said bottom face; and
iv) an opening in said first plate in registry with said aperture and intermediate the ends of said second plate extending through said first plate providing a cavity (12) in fluid communication with all said channels;
whereby said thermally conductive body defines a plurality of channels extending in generally opposite directions from said opening; and
b) a fan 14 positioned within said cavity and adapted to draw air through said aperture and into said housing.

22. Apparatus as claimed in claim 21 in which said at least one wall of said housing forms said first plate.
